# EUROPEAN PATENT APPLICATION

(11) **EP 4 547 000 A1**
(43) Date of publication of application: **30.04.2025**
(21) Application number: 24206913.6
(22) Date of filing: 16.10.2024
(51) Int. Cl.: H10N 70/20, H10B 63/00, G11C 11/56

(54) **CHALCOGENIDE-BASED MEMORY DEVICE FOR IMPLEMENTING MULTI-LEVEL MEMORY AND ELECTRONIC APPARATUS INCLUDING THE CHALCOGENIDE-BASED MEMORY DEVICE**

(30) Priority: 24.10.2023 KR 20230143247
(71) Applicant: Samsung Electronics Co., Ltd, Suwon-si, Gyeonggi-do 16677 (KR)
(72) Inventor: CHOI, Minwoo, 16678 Suwon-si (KR); SUNG, Hajun, 16678 Suwon-si (KR); KOO, Bonwon, 16678 Suwon-si (KR); YANG, Kiyeon, 16678 Suwon-si (KR); LEE, Changseung, 16678 Suwon-si (KR)
(74) Representative: Elkington and Fife LLP

(57) **Abstract**

Provided are a chalcogenide-based memory device capable of implementing multi-level memory and an electronic apparatus including said memory device. The memory device (100) includes a memory layer (130), provided between a first electrode (110) and a second electrode (120), which includes a plurality of memory material layers (131, 132, 133) having threshold voltages that are different from each other, preferably connected in parallel. Each memory material layer includes a chalcogenide-based material, has an ovonic threshold switching (OTS) characteristic, and is configured to have a threshold voltage that varies depending on a polarity and intensity of an applied voltage.

## Description

### FIELD OF THE INVENTION

One or more embodiments relate to a chalcogenide-based memory device for implementing a multi-level memory and an electronic device including the chalcogenide-based memory device.

### BACKGROUND OF THE INVENTION

According to the trend toward lighter, thinner, and smaller electronic devices and appliances, the demand for high integration of memory devices has also increased. In a memory device having a cross-point structure, word lines and bit lines perpendicularly cross each other and a memory cell is disposed at each of the intersection regions. The above structure has memory cells with a small planar size. In general, a memory cell in a memory device having a cross-point structure includes a 2-terminal selector and a memory device that are connected in series to prevent and/or mitigate a flow of a sneak current between neighboring memory cells. As such, an aspect ratio of a unit memory cell increases, and thus, processes for manufacturing a memory cell are complicated and there is a limitation in increasing a memory capacity of a memory device.

### SUMMARY OF THE INVENTION

Provided are a chalcogenide-based memory device for implementing a multi-level memory and an electronic device including the chalcogenide-based memory device.

Additional aspects will be set forth in part in the description which follows and, in part, will be apparent from the description, or may be learned by practice of the presented embodiments of the disclosure.

According to at least one embodiment, provided is a memory device including a first electrode and a second electrode spaced apart from each other, and a memory layer between the first electrode and the second electrode, the memory layer including a plurality of memory material layers having different threshold voltages from each other, and wherein each of the plurality of memory material layers includes a chalcogenide-based material, has an ovonic threshold switching (OTS) characteristic, and is configured to have a threshold voltage varying depending on a polarity and intensity of an applied voltage.

Each of the plurality of memory material layers may include a chalcogen element including at least one of Se and Te, and at least one of Ge, As, and Sb.

At least one of the plurality of memory material layers may further include at least one of In, Al, C, B, Sr, Ga, O, N, Si, Ca, P, and S.

The plurality of memory material layers may have different threshold voltages according to a composition or a composition and a thickness thereof.

The plurality of memory material layers may be arranged perpendicularly to the first and second electrodes and are electrically connected to one another in parallel.

The plurality of memory material layers may be arranged in parallel to each other when in a plan view.

The plurality of memory material layers may be arranged in concentric circles when in a plan view.

When the number of the plurality of memory material layers is n, the memory device may be configured to implement 2*(n+1) level states.

Each of the plurality of memory material layers may be configured to implement a low-threshold voltage state and a high-threshold voltage state by using writing voltage pulses of different polarities.

According to another embodiment, a memory device includes a plurality of memory cells, and each of the memory cells includes a first electrode and a second electrode spaced apart from each other; and a memory layer between the first electrode and the second electrode, the memory layer including a plurality of memory material layers having different threshold voltages, and wherein each of the plurality of memory material layers includes a chalcogenide-based material, has an ovonic threshold switching (OTS) characteristic, and is configured to have a threshold voltage varying depending on a polarity and intensity of an applied voltage.

Each of the plurality of memory material layers may include a chalcogen element including at least one of Se or Te, and at least one of Ge, As, or Sb.

Each of the plurality of memory material layers may further include at least one of In, Al, C, B, Sr, Ga, O, N, Si, Ca, P, or S.

The plurality of memory material layers may have different threshold voltages according to a composition or a composition and a thickness thereof.

The plurality of memory material layers may be arranged perpendicularly to the first and second electrodes and are electrically connected to one another in parallel.

When the number of the plurality of memory material layers is n, the memory cell may be configured to implement 2*(n+1) level states.

Each of the plurality of memory material layers may be configured to implement a low-threshold voltage state and a high-threshold voltage state by using writing voltage pulses of different polarities.

The memory device may include a plurality of bit lines extending in a first direction, and a plurality of word lines extending in a second direction crossing the first direction, and the plurality of memory cells are respectively provided at points where the plurality of bit lines and the plurality of word lines cross each other.

The memory device may include a plurality of word planes that extend along a plane including the first direction and the second direction and are arranged to be spaced apart from each other in the third direction, and a vertical bit line passing through the plurality of word planes and extending in the third direction, and the memory layer may be provided between the vertical bit line and each of the word planes.

The plurality of memory material layers may be stacked in the third direction.

According to another embodiment, an electronic apparatus includes the memory device described above.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view of a memory device according to at least one embodiment;
FIG. 2 is a graph showing an example of a voltage-current characteristic of a memory layer in a memory device according to at least one embodiment;
FIG. 3A is a graph showing an example of a bias volage for performing a set operation and a read operation in a memory device according to at least one embodiment;
FIG. 3B is a graph showing an example of a bias volage for performing a reset operation and a read operation in a memory device according to at least one embodiment;
FIG. 4 is a graph showing an example of a voltage-current characteristic according to a polar magnitude of a writing voltage applied to a memory layer during a reset operation of a memory device according to at least one embodiment;
FIG. 5 is a diagram showing changes in a reset threshold voltage and a set threshold voltage according to a writing voltage applied to a memory layer in a memory device according to at least one embodiment;
FIG. 6A is a cross-sectional view schematically showing a memory device according to another embodiment;
FIG. 6B is a plan view of a memory layer of FIG. 6A;
FIG. 7 is a circuit diagram of a memory device of FIG. 6A;
FIG. 8 is a graph showing an example of a voltage-current characteristic with respect to each of first, second, and third memory material layers shown in FIG. 6A;
FIG. 9 is a graph showing a voltage-current characteristic with respect to a memory layer including first, second, and third memory material layers shown in FIG. 6A;
FIG. 10 is a diagram showing resistance states of first, second, and third memory material layers when a writing voltage applied to the memory device of FIG. 6A is less than a first threshold voltage;
FIG. 11 is a diagram showing resistance states of first, second, and third memory material layers when a writing voltage applied to the memory device of FIG. 6A is greater than a first threshold voltage and less than a second threshold voltage;
FIG. 12 is a diagram showing resistance states of first, second, and third memory material layers when a writing voltage applied to the memory device of FIG. 6A is greater than a second threshold voltage and less than a third threshold voltage;
FIG. 13 is a diagram showing resistance states of first, second, and third memory material layers when a writing voltage applied to the memory device of FIG. 6A is greater than a third threshold voltage;
FIG. 14 is a diagram showing that a first memory material layer may implement two resistance states according to a bias voltage when a threshold voltage is less than a first threshold voltage as shown in FIG. 10;
FIG. 15 is a diagram showing an example of a method of manufacturing the memory device shown in FIG. 6A;
FIG. 16 is a diagram showing another example of a method of manufacturing the memory device of FIG. 6A;
FIG. 17A is a schematic cross-sectional view of a memory device according to another embodiment;
FIG. 17B is a plan view of a memory layer of FIG. 17A;
FIG. 18 is a perspective view schematically showing a memory device according to another embodiment;
FIG. 19 is a diagram showing an enlarged view of one memory cell in a memory device of FIG. 18;
FIG. 20 is a plan view showing an example of an operation for selecting a certain memory cell in a memory device of FIG. 18;
FIG. 21 is a perspective view schematically showing a memory device according to at least one embodiment;
FIG. 22 is a cross-sectional view schematically showing a structure of one memory cell in a memory device of FIG. 21;
FIG. 23 is a conceptual diagram schematically showing a device architecture that may be applied to an example of an electronic apparatus;
FIG. 24 is a block diagram of a memory system according to at least one embodiment; and
FIG. 25 is a block diagram showing a neuromorphic device and an external device connected to the neuromorphic device according to at least one embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. When the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical and/or geometric values.

Hereinafter, one or more embodiments of the present disclosure will be described in detail with reference to accompanying drawings. In the drawings, like reference numerals denote like components, and sizes of components in the drawings may be exaggerated for convenience of explanation. The embodiments of the disclosure are capable of various modifications and may be embodied in many different forms.

When a layer, a film, a region, or a panel is referred to as being "on" another element, it may be directly on/under/at left/right sides of the other layer or substrate, or intervening layers may also be present. Additionally, it will also be understood that spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. An expression used in the singular encompasses the expression of the plural, unless it has a clearly different meaning in the context. It will be further understood that when a portion is referred to as "comprising" another component, the portion may not exclude another component but may further comprise another component unless the context states otherwise.

The use of the term of "the above-described" and similar indicative terms may correspond to both the singular forms and the plural forms. Also, the steps of all methods described herein may be performed in any suitable order unless otherwise indicated herein or otherwise clearly contradicted by context.

Also, the terms "... unit", "... module" used herein specify a unit for processing at least one function or operation, and this may be implemented as processing circuitry such as hardware or software or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

Furthermore, the connecting lines or connectors shown in the drawings are intended to represent example functional relationships and/or physical or logical couplings between the various elements. It should be noted that many alternative or additional functional relationships, physical connections, or logical connections may be present in a practical device.

The use of any and all examples, or example language provided herein, is intended merely to better illuminate the disclosure and does not pose a limitation on the scope of the present disclosure unless otherwise claimed.

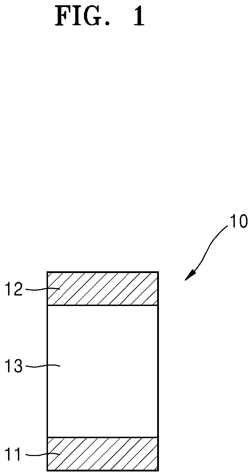

FIG. 1 is a cross-sectional view schematically showing a memory device 10 according to at least one embodiment.

Referring to FIG. 1, the memory device 10 may include a first electrode 11, a second electrode 12 that is spaced apart from the first electrode 11 so as to face the first electrode 11, and a memory layer 13 disposed between the first electrode 11 and the second electrode 12.

The first electrode 11 and the second electrode 12 may apply a voltage to the memory layer 13. To do this, the first electrode 11 and the second electrode 12 may each include a conductive material, such as a metal, a conductive metal nitride, a conductive metal oxide, and/or a combination thereof. For example, the first electrode 11 and the second electrode 12 may each include at least one of titanium nitride (TiN), titanium silicon nitride (TiSiN), titanium carbon nitride (TiCN), titanium carbon silicon nitride (TiCSiN), tantalum (Ta), tantalum nitride (TaN), tantalum silicon nitride (TaSiN), tantalum aluminum nitride (TaAlN), tungsten silicide (WSi), titanium tungsten (TiW), molybdenum nitride (MoN), niobium nitride (NbN), titanium boron nitride (TiBN), zirconium silicon nitride (ZrSiN), tungsten silicon nitride (WSiN), tungsten boron nitride (WBN), zirconium aluminum nitride (ZrAIN), molybdenum aluminum nitride (MoAIN), titanium aluminum (TiAl), titanium oxygen nitride (TiON), titanium aluminum oxygen nitride (TiAlON), tungsten oxygen nitride (WON), tantalum oxygen nitride (TaON), silicon carbon (SiC), silicon carbon nitride (TiON), carbon nitride (CN), tantalum carbon nitride (TaCN), tungsten (W), tungsten nitride (WN), and carbon (C), a combination thereof, and/or the like.

The memory layer 13 may be configured to have an ovonic threshold switching (OTS) characteristic which has a high-resistive state when being applied with a voltage less than a threshold voltage and has a low-resistive state when being applied with a voltage greater than the threshold voltage. In addition, the memory layer 13 may have a memory characteristic in which a threshold voltage is shifted, e.g., according to a polarity and intensity of a bias voltage applied thereto. Therefore, the memory layer 13 may have a self-selecting memory characteristic, by which a memory function and a selector function may be both performed only with a single material.

The memory layer 13 may include a chalcogenide-based material. For example, the memory layer 13 may include a chalcogen element including at least one of Se and Te, and at least one of Ge, As, and Sb. Also, the memory layer may further include at least one of In, Al, C, B, Sr, Ga, O, N, Si, Ca, P, and S. For example, the memory layer 13 may include at least one of GeAsSe, GeAsSeIn, GeAsSeSIn, GeAsSeSb, GeAsSeTe, GeAsSeAl, GeAsSeAlIn, GeSbSe, GeSbSeN, and/or the like.

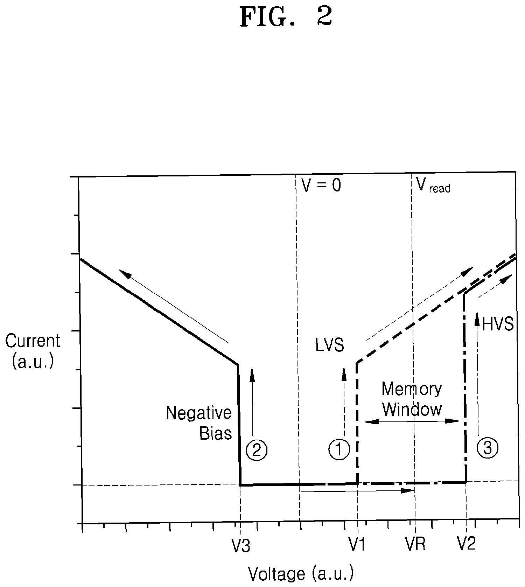

FIG. 2 is a graph showing an example of a voltage-current characteristic of the memory layer 13 in the memory device 10 according to at least one embodiment.

Referring to FIG. 2, the memory layer 13 may have one of a first state (LVX; low-Vth state) in which the threshold voltage is relatively low and a second state (HVS; high-Vth state) in which the threshold voltage is relatively high. For example, in the first state, the threshold voltage of the memory layer 13 may be a first voltage V1, and in the second state, the threshold voltage of the memory layer 13 may be a second voltage V2 that is greater than the first voltage V1.

While the memory layer 13 is in the first state, when a voltage less than the first voltage V1 is applied to the memory layer 13, a current rarely flows between both ends of the memory layer 13, and when a voltage greater than the first voltage V1 is applied to the memory layer 13, the memory layer 13 is turned on and the current flows through the memory layer 13. Also, while the memory layer 13 is in the second state, when a voltage less than the second voltage V2 is applied to the memory layer 13, the current rarely flows between both ends of the memory layer 13, and when a voltage greater than the second voltage V2 is applied to the memory layer 13, the memory layer 13 is turned on and the current flows through the memory layer 13.

Therefore, a voltage between the first voltage V1 and the second voltage V2 may be selected as a read voltage VR. When the memory layer 13 is in the first state and the read voltage VR is applied to the memory layer 13, the current flows through the memory layer 13, and at this time, a value of data stored in the memory layer 13 may be defined as "1". When the memory layer 13 is in the second state and the read voltage VR is applied to the memory layer 13, the current rarely flows through the memory layer 13, and at this time, a value of data stored in the memory layer 13 may be defined as "0". In other words, when the current flowing through the memory layer 13 while applying the read voltage VR to the memory layer 13 is measured, a value of data stored in the memory layer 13 may be read.

In addition, when the memory layer 13 is in the first state and a negative bias voltage is applied to the memory layer 13, the threshold voltage of the memory layer 13 increases and the memory layer 13 may be converted into the second state, e.g., through a phase change. For example, when a negative third voltage V3 is applied to the memory layer 13, the memory layer 13 may be converted into the second state. The above operation may be referred to as a reset operation. Also, when the memory layer 13 is in the second state and a positive (+) bias voltage greater than the second voltage V2 is applied to the memory layer 13, the threshold voltage of the memory layer 13 decreases and the memory layer 13 may be converted into the first state. The above operation may be referred to as a set operation. A difference between the second voltage V2 (e.g., a reset threshold voltage) and the first voltage V1(e.g., a set threshold voltage) corresponds to a memory window.

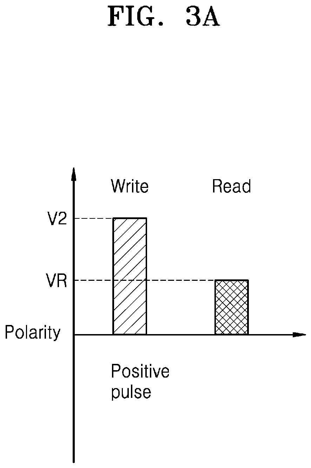

FIG. 3A is a graph showing an example of a bias voltage for a set operation and a read operation in the memory device 10 according to at least one embodiment. Referring to FIG. 3A, a positive bias voltage that is greater than or equal to the second voltage V2 may be applied to the memory layer 13 in the set operation. Then, the threshold voltage of the memory layer 13 may be shifted into the first voltage V1. After that, in the read operation, a positive read voltage VR between the first voltage V1 and the second voltage V2 may be applied to the memory layer 13. When the read voltage VR is applied, the memory layer 13 may be turned on.

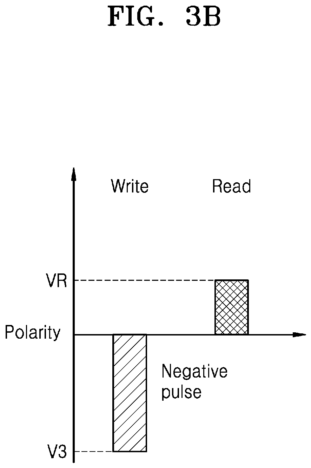

FIG. 3B is a graph showing an example of a bias voltage for a reset operation and a read operation in the memory device 10 according to at least one embodiment. Referring to FIG. 3B, in the reset operation, a negative bias voltage, that is, the third voltage V3, may be applied to the memory layer 13. An absolute value of the third voltage V3 may be equal to the second voltage V2, or may be slightly less or greater than the second voltage V2. Then, the threshold voltage of the memory layer 13 may be shifted to the second voltage V2 that is greater than the first voltage V1. After that, in the read operation, a positive read voltage VR between the first voltage V1 and the second voltage V2 may be applied to the memory layer 13. When the read voltage VR is applied, the memory layer 13 may be turned off.

As described above, the memory layer 13 of the memory device 10 may have an OTS characteristic, and at the same time, the memory characteristic of changing the threshold voltage. In particular, the threshold voltage of the memory layer 13 may be shifted according to the polarity of the bias voltage applied to the memory layer 13. In this point of view, the memory device 10 may be a self-selecting memory device having a polarity-dependent threshold voltage shift characteristic.

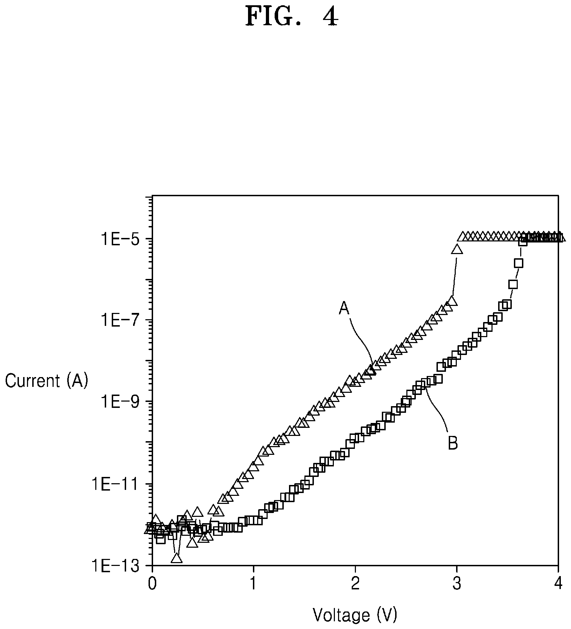

FIG. 4 is a graph showing an example of a voltage-current characteristic according to a polar magnitude of a writing voltage applied to the memory layer 13 during a reset operation of the memory device 10 according to the embodiment. In FIG. 4, "B" denotes a voltage-current characteristic when (-) polarity of the writing voltage is greater as compared with "A". Referring to FIG. 4, as the magnitude of (-) polarity in the writing voltage applied to the memory layer 13 increases, a threshold voltage increases and a resistance also increases.

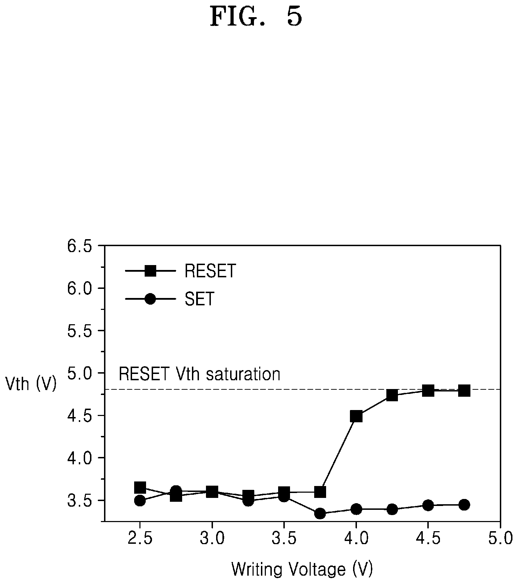

FIG. 5 is a diagram showing changes in a reset threshold voltage and a set threshold voltage according to a writing voltage applied to the memory layer 13 in the memory device 10 according to the embodiment. In FIG. 5, a writing voltage of a positive (+) polarity is used to measure a set threshold voltage and a writing voltage of a negative (-) polarity is used to measure a reset threshold voltage. Referring to FIG. 5, as the writing voltage applied to the memory layer 13 increases, a reset threshold voltage RESET Vth is saturated.

In the memory device 10 of FIG. 1, there is a limitation in implementing multi-levels through the control of the writing voltage, due to a saturation effect of the threshold voltage occurring in the memory layer 13. Also, the chalcogenide-based material forming the memory layer 13 may show a characteristic shift over time due to amorphous stability, and there is a difficulty in implementing the multi-level due to the characteristic shift.

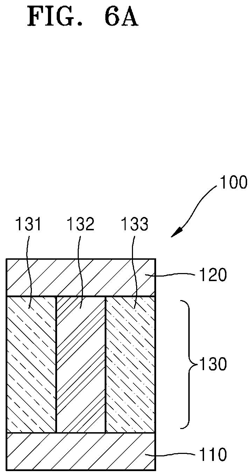

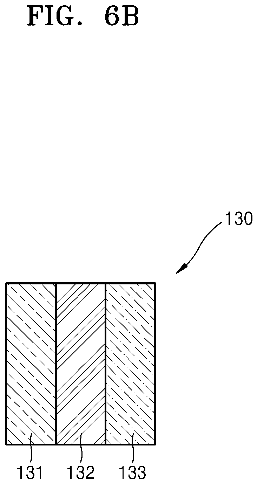

FIG. 6A is a cross-sectional view schematically showing a memory device 100 according to at least one embodiment. FIG. 6B is a plan view of the memory layer 130 of FIG. 6A.

Referring to FIGS. 6A and 6B, the memory device 100 includes first and second electrodes 110 and 120 that are spaced apart from each other, and the memory layer 130 arranged between the first and second electrodes 110 and 120. The first and second electrodes 110 and 120 are respectively the same as (and/or substantially similar to) the first and second electrodes 11 and 12 shown in FIG. 1, and detailed descriptions thereof are omitted.

The memory layer 130 includes first, second, and third memory material layers 131, 132, and 133 arranged between the first and second electrodes 110 and 120. The first, second, and third memory material layers 131, 132, and 133 may be arranged perpendicularly to the first and second electrodes 110 and 120. The first, second, and third memory material layers 131, 132, and 133 may be arranged parallel to one another when seen from a plane. Each of the first, second, and third memory material layers 131, 132, and 133 may have a self-selecting memory characteristic configured to perform both as a memory and a selector, like the memory layer 13 shown in FIG. 1. That is, each of the first, second, and third memory material layers 131, 132, and 133 may have an ovonic threshold switching (OTS) characteristic and may be configured to have a threshold voltage that varies depending on a polarity and intensity of an applied voltage.

Each of the first, second, and third memory material layers 131, 132, and 133 may include a chalcogenide-based material. For example, each of the first, second, and third memory material layers 131, 132, and 133 may include a chalcogen element including at least one of Se and Te, and at least one of Ge, As, and Sb. Also, each of the first, second, and third memory material layers 131, 132, and 133 may further include at least one of In, Al, C, B, Sr, Ga, O, N, Si, Ca, P, and S. For example, each of the first, second, and third memory material layers 131, 132, and 133 may include at least one of GeAsSe, GeAsSeIn, GeAsSeSIn, GeAsSeSb, GeAsSeTe, GeAsSeAl, GeAsSeAlIn, GeSbSe, GeSbSeN, and/or the like. However, one or more embodiments are not limited thereto.

The first, second, and third memory material layers 131, 132, and 133 may be formed to have different threshold voltages from one another. For example, the first memory material layer 131 has a first threshold voltage Vth1, the second memory material layer 132 has a second threshold voltage Vth2, and the third memory material layer 133 has a third threshold voltage Vth3. The first, second, and third memory material layers 131, 132, and 133 having different threshold voltages may be formed by adjusting a composition or a composition and thickness of the chalcogenide-based material having the self-selecting memory characteristic.

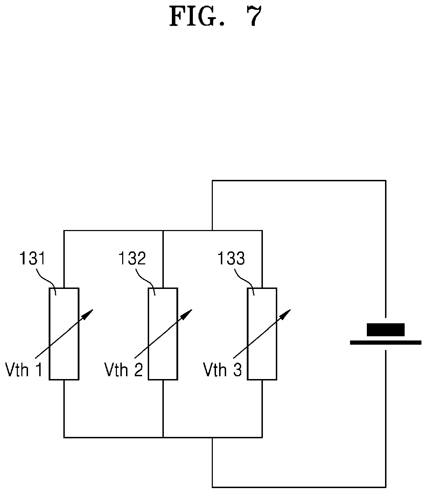

FIG. 7 is a schematic circuit diagram of the memory device 100 of FIG. 6A. Referring to FIG. 7, the first, second, and third memory material layers 131, 132, and 133 forming the memory layer 130 may be electrically connected to one another in parallel with each other between the first and second electrodes 110 and 120.

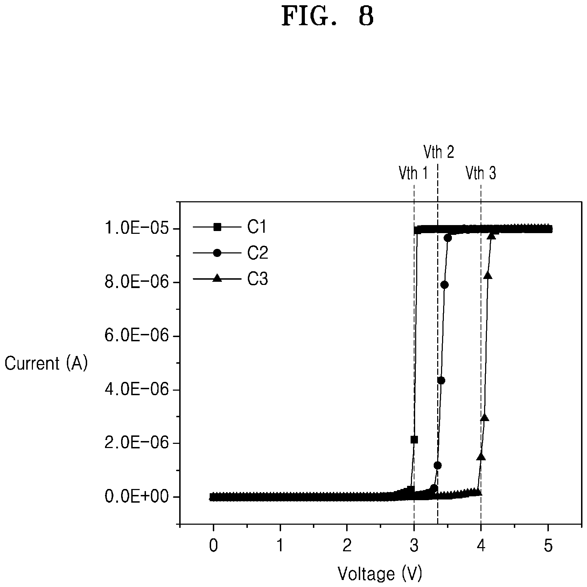

FIG. 8 is a graph showing an example of a voltage-current characteristic with respect to each of the first, second, and third memory material layers 131, 132, and 133 shown in FIG. 6A. In FIG. 8, C1 denotes a voltage-current characteristic of the first memory material layer 131, C2 denotes a voltage-current characteristic of the second memory material layer 132, and C3 denotes a voltage-current characteristic of the third memory material layer 133.

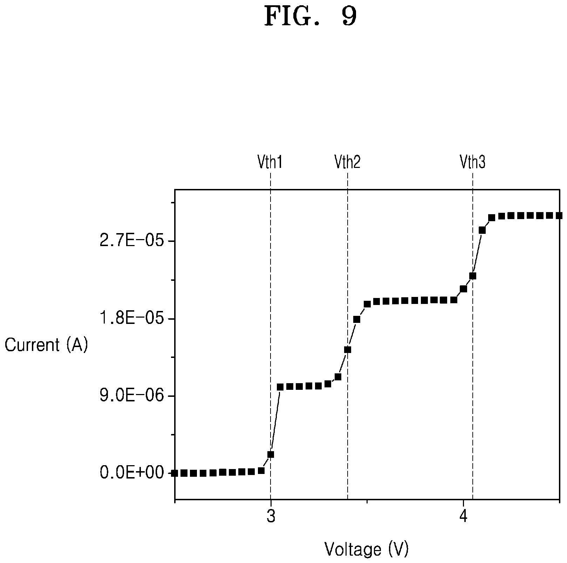

Referring to FIG. 8, the first memory material layer 131 has the first threshold voltage Vth1, the second memory material layer 132 has the second threshold voltage Vth2 that is greater than the first threshold voltage Vth1, and the third memory material layer 133 has the third threshold voltage Vth3 that is greater than the second threshold voltage Vth2. In addition, FIG. 9 shows an example of a voltage-current characteristic of the memory layer 130 including the first, second, and third memory material layers 131, 132, and 133 shown in FIG. 8.

Hereinafter, a method of implementing the multi-level memory by using the memory device 100 is described below. Hereinafter, it is assumed that the first memory material layer 131 has the first threshold voltage Vth1, the second memory material layer 132 has the second threshold voltage Vth2 that is greater than the first threshold voltage Vth1, and the third memory material layer 133 has the third threshold voltage Vth3 that is greater than the second threshold voltage Vth2 (that is, Vth1 < Vth2 < Vth3).

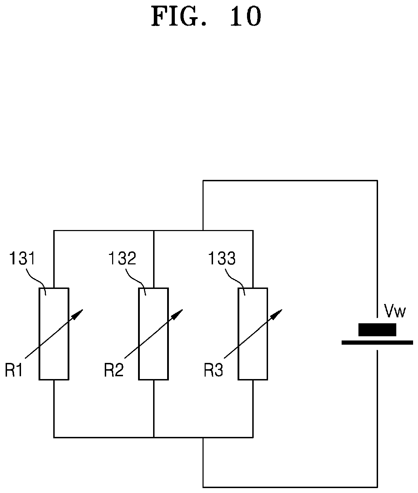

FIG. 10 is a diagram showing resistance states of the first, second, and third memory material layers 131, 132, and 133 when a writing voltage applied to the memory device 100 of FIG. 6A is less than a first threshold voltage.

Referring to FIG. 10, when a writing voltage Vw applied between the first and second electrodes 110 and 120 is less than the first threshold voltage Vth1 (Vw < Vth1), the first, second, and third memory material layers 131, 132, and 133 are not turned on and maintain the set states. Hereinafter, the resistance states of the first, second, and third memory material layers 131, 132, and 133 may be respectively R1, R2, and R3.

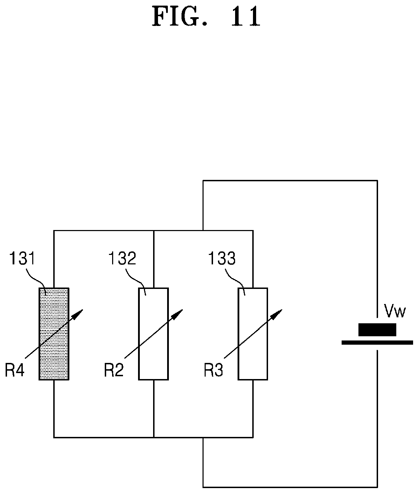

FIG. 11 is a diagram showing resistance states of first, second, and third memory material layers 131, 132, and 133 when a writing voltage applied to the memory device 100 of FIG. 6A is greater than a first threshold voltage and less than a second threshold voltage.

Referring to FIG. 11, when the writing voltage Vw applied between the first and second electrodes 110 and 120 is greater than the first threshold voltage Vth1 and less than the second threshold voltage Vth2 (Vth1 < Vw < Vth2), the first memory material layer 131 is turned on and forms a reset state. Here, the resistance state of the first memory material layer 131 may be R4. In addition, the second and third memory material layers 132 and 133 are not turned on and are maintained in the set states. Here, the resistance states of the second and third memory material layers 132 and 133 may be respectively R2 and R3. Therefore, the resistance states of the first, second, and third memory material layers 131, 132, and 133 may be respectively R4, R2, and R3.

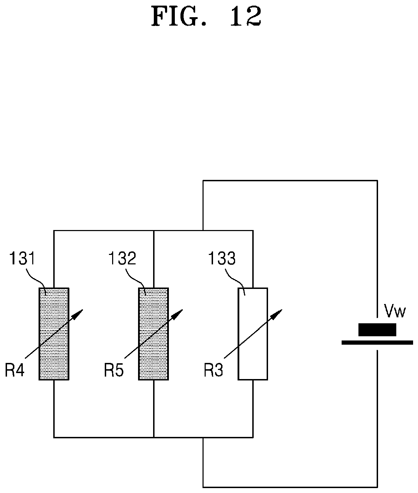

FIG. 12 is a diagram showing resistance states of first, second, and third memory material layers 131, 132, and 133 when the writing voltage Vw applied to the memory device 100 of FIG. 6A is greater than the second threshold voltage Vth2 and less than the third threshold voltage Vth3.

Referring to FIG. 12, when the writing voltage Vw applied between the first and second electrodes 110 and 120 is greater than the second threshold voltage Vth2 and less than the third threshold voltage Vth3 (Vth2 < V2 < Vth3), the first and second memory material layers 131 and 132 are turned on and form reset states. Here, the resistance states of the first and second memory material layers 131 and 132 may be respectively R4 and R5. In addition, the third memory material layer 133 is not turned on and is maintained in the set state. Here, the resistance state of the third memory material layer 133 may be R3. Therefore, the resistance states of the first, second, and third memory material layers 131, 132, and 133 may be respectively R4, R5, and R3.

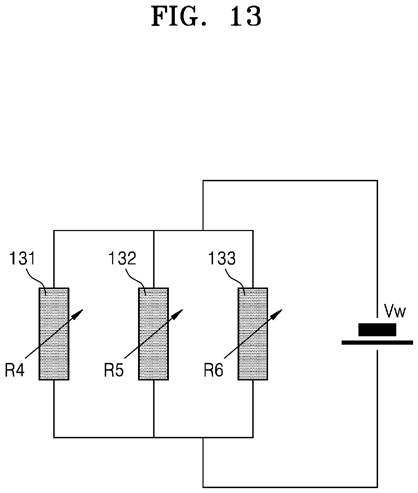

FIG. 13 is a diagram showing resistance states of the first, second, and third memory material layers 131, 132, and 133 when the writing voltage Vw applied to the memory device 100 of FIG. 6A is greater than the third threshold voltage Vth3.

Referring to FIG. 13, when the writing voltage Vw applied between the first and second electrodes 110 and 120 is greater than the third threshold voltage Vth3 (Vw > Vth3), the first, second, and third memory material layers 131, 132, and 133 are turned on and form the reset states. Hereinafter, the resistance states of the first, second, and third memory material layers 131, 132, and 133 may be respectively R4, R5, and R6.

Referring to FIGS. 10 to 13, when the memory layer 130 includes the first, second, and third memory material layers 131, 132, and 133 having different threshold voltages from one another, the memory layer 130 may indicate four resistance states according to the writing voltage Vw.

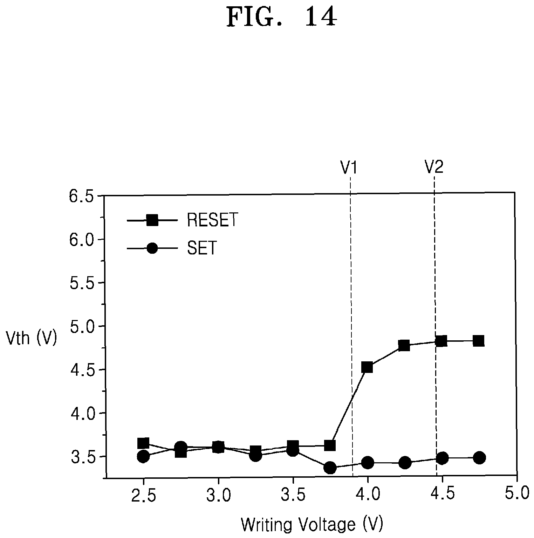

FIG. 14 is a diagram showing that the first memory material layer 131 may implement two resistance states according to a bias voltage when the threshold voltage Vw is less than the first threshold voltage Vth1 as shown in FIG. 10 (Vw < Vth1).

Referring to FIG. 14, when the writing voltage Vw is less than the first threshold voltage Vth1 becomes the first voltage V1 of a positive polarity, the first memory material layer 131 maintains the set state as described above. Here, the resistance state of the first memory material layer 131 is R1. In addition, when the writing voltage Vw is less than the first threshold voltage Vth1 becomes the second voltage V2 of negative voltage, the first memory material layer 131 may form an intermediate state between the set state and the reset state. Here, the resistance state of the first memory material layer 131 is R1'. As described above, when the writing voltage Vw is less than the first threshold voltage Vth1, the first memory material layer 131 may implement two resistance states R1 and R1' according to the bias voltage.

Similarly, when the writing voltage Vw is greater than the first threshold voltage Vth1 of the first memory material layer 131 and less than the second threshold voltage Vth2 (Vth1 < Vw < Vth2), the second memory material layer 132 may implement two resistance states R2 and R2' according to the bias voltage. Also, when the writing voltage Vw is greater than the second threshold voltage Vth2 and less than the third threshold voltage Vth3 (Vth2 < Vw < Vth3), the third memory material layer 133 may implement two resistance states R3 and R3' according to the bias voltage. In addition, when the writing voltage V2 is greater than the third threshold voltage Vth3 (Vw > Vth3), the third memory material layer 133 may implement two resistance states R6 and R6' according to the bias voltage.

As described above, when the memory layer 130 includes the first, second, and third memory material layers 131, 132, and 133 having different threshold voltages, eight resistance states may be implemented. Accordingly, the memory device 100 according to the embodiment may implement a multi-level memory.

In addition, in the above description, the memory layer 130 includes three memory material layers 131, 132, and 133 having different threshold voltages. However, one or more embodiments are not limited to the example, and the memory layer 130 may include two, four or greater memory material layers. When the threshold voltage of the memory layer 130 includes n different memory material layers, the memory layer 130 may implement 2*(n+1) resistance states.

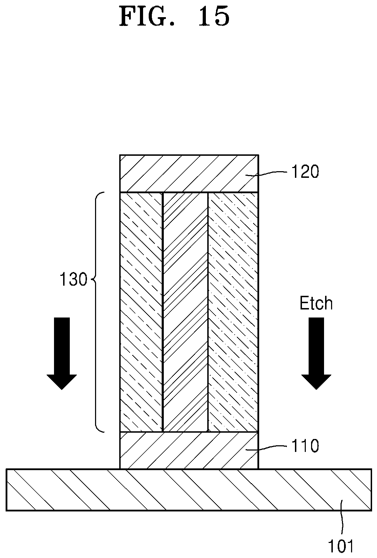

FIG. 15 is a diagram showing an example method of manufacturing the memory device 100 shown in FIG. 6A. Referring to FIG. 15, the first electrode 110, the memory layer 130, and the second electrode 120 are sequentially deposited on the substrate 101, and the deposited layers are integrally etched by using an etching mask (not shown) to form the memory device 100 of a pillar structure.

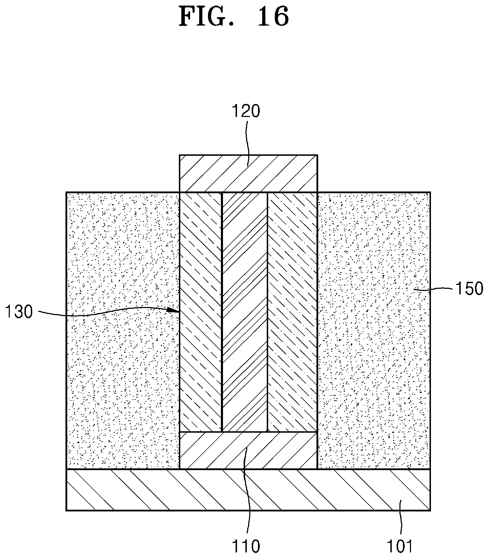

FIG. 16 is a diagram showing another example method of manufacturing the memory device 100 shown in FIG. 6A. Referring to FIG. 16, a dielectric layer 150 is formed on the substrate 101, and then, a trench is formed in the dielectric layer 150 to a certain length. Here, the trench may be formed to expose an upper surface of the substrate 101. Next, the first electrode 110 and the memory layer 130 are deposited from the bottom of the trench. Next, after performing a planarization process on the upper portion of the memory layer 130, the second electrode 120 is formed on the upper surface of the memory layer that is planarized and the memory device 100 may be formed. After that, the substrate 101 and the dielectric layer 150 may be removed.

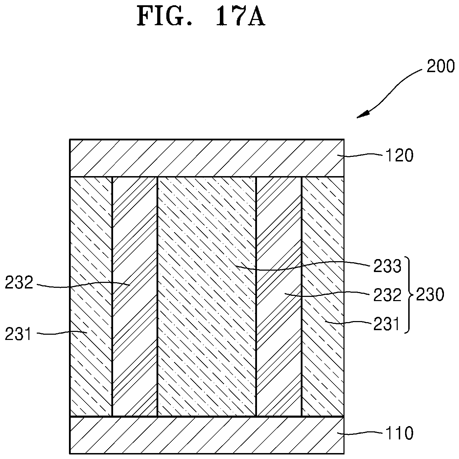

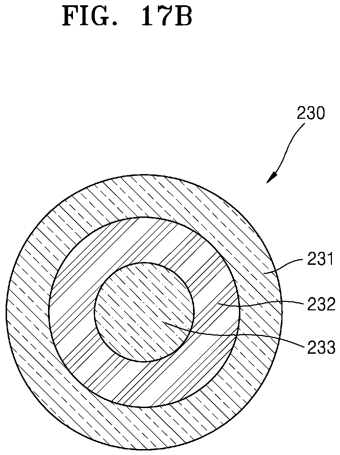

FIG. 17A is a cross-sectional view schematically showing a memory device 200 according to at least one embodiment. FIG. 17B is a plan view of a memory layer 230 of FIG. 17A. Hereinafter, differences from the above-described embodiments will be described.

The memory layer 230 is provided between the first and second electrodes 110 and 120, and the memory layer 230 includes first, second, and third memory material layers 231, 232, and 233 having different threshold voltages from one another. The first, second, and third memory material layers 231, 232, and 233 may be arranged perpendicularly to the first and second electrodes 110 and 120. Here, the first, second, and third memory material layers 231, 232, and 233 may be arranged as concentric circles when viewed from a plane. In detail, the second memory material layer 232 is provided to surround the side surfaces of the third memory material layer 233, and the first memory material layer 231 may be provided to surround the side surfaces of the second memory material layer 232. The first, second, and third memory material layers 231, 232, and 233 are electrically connected to one another in parallel between the first and second jaws 110 and 120. The first, second, and third memory material layers 231, 232, and 233 are described above, and detailed descriptions are omitted.

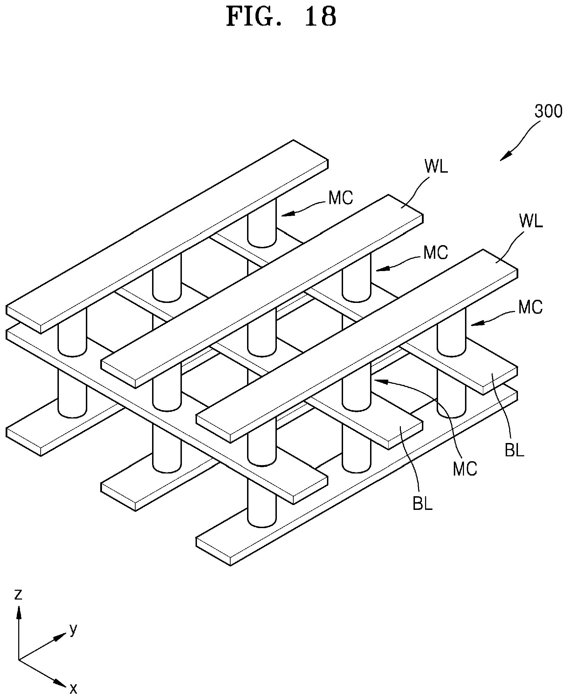

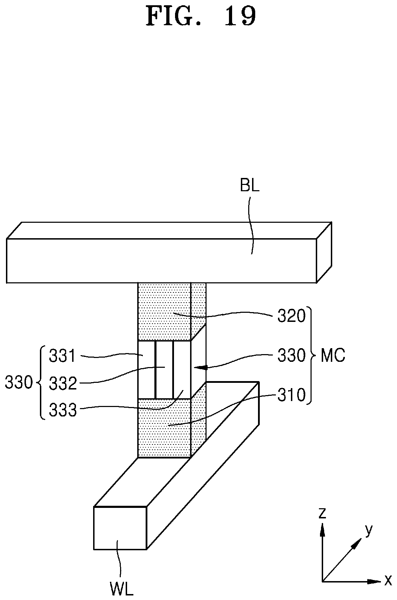

FIG. 18 is a perspective view schematically showing a memory device 300 according to at least one embodiment. FIG. 19 is a diagram showing an enlarged view of one memory cell MC in the memory device 300 of FIG. 18.

Referring to FIG. 18 and FIG. 19, the memory device 300 may have a three-dimensional (3D) cross-point structure. For example, the memory device 300 may include a plurality of bit lines BL extending in a first direction (that is, x-axis direction), a plurality of word lines WL extending in a second direction (that is, y-axis direction) crossing the first direction, and a plurality of memory cells MC provided on points where the plurality of bit lines BL and the plurality of word lines WL cross each other.

Each of the plurality of memory cells MC may correspond to the memory device 100 shown in, e.g., FIG. 6A. In detail, a lower electrode 310 and an upper electrode 320 may correspond respectively to the first electrode 110 and the second electrode 120 of the memory device 100 shown in FIG. 6A. The memory layer 330 may include a plurality of memory material layers 331, 332, and 333 having different threshold voltages. The memory layer 330 may correspond to the memory layer 130 of the memory device 100 shown in FIG. 6A. Therefore, the memory layer 330 may have the same characteristics as those of the memory layer 130 in the memory device 100 of FIG. 6A. In addition, each of the plurality of memory cells MC may correspond to the memory device 200 shown in FIG. 17A.

In this structure, the memory cell MC may be driven by a potential difference between the word line WL and the bit line BL connected to both ends of each memory cell MC. Therefore, each memory cell MC may implement a multi-level memory as described above.

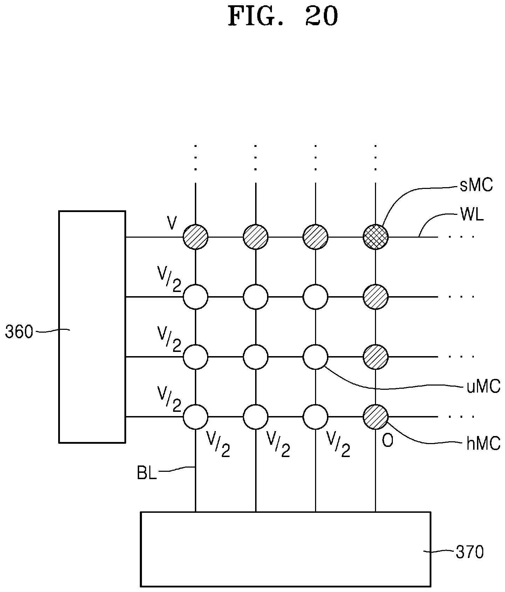

FIG. 20 is a plan view showing an example of an operation for selecting a certain memory cell MC in the memory device 300 of FIG. 18.

Referring to FIG. 20, the memory device 300 may further include a row decoder 360 selectively supplying a voltage to the plurality of word lines WL, and a column decoder 370 selectively supplying a voltage to the plurality of bit lines BL. When a voltage V is to be applied to one selected memory cell sMC from among the plurality of memory cells MC, the row decoder 360 may provide the voltage V to the word line WL connected to the selected memory sMC and a voltage V/2 to the other word lines WL. Here, the column decoder 370 may provide a voltage of 0 V to the bit line BL connected to the selected memory sMC and provide a voltage V/2 to the other bit lines BL.

Then, the potential difference between the word line WL and the bit line BL of the selected memory cell sMC is V. On the other hand, the potential difference between the word line WL to which the voltage V/2 is supplied and the bit line BL to which the voltage V/2 is supplied is 0 V. Therefore, the voltage is not applied to a non-selected memory cell uMC arranged between the word line WL and the bit line BL that are not connected to the selected memory cell sMC. In addition, a voltage V/2 may be applied to both ends of a half-selected memory cell hMC that is connected to the word line WL same as that of the selected memory cell sMC or the bit line BL same as that of the selected memory cell sMC. Each of the plurality of memory cells MC is a self-selecting memory device as described above, and thus, the half-selected memory cell hMC adjacent to the selected memory cell sMC is not turned on even when being applied with the voltage V/2, and accordingly, a sneak current rarely occurs.

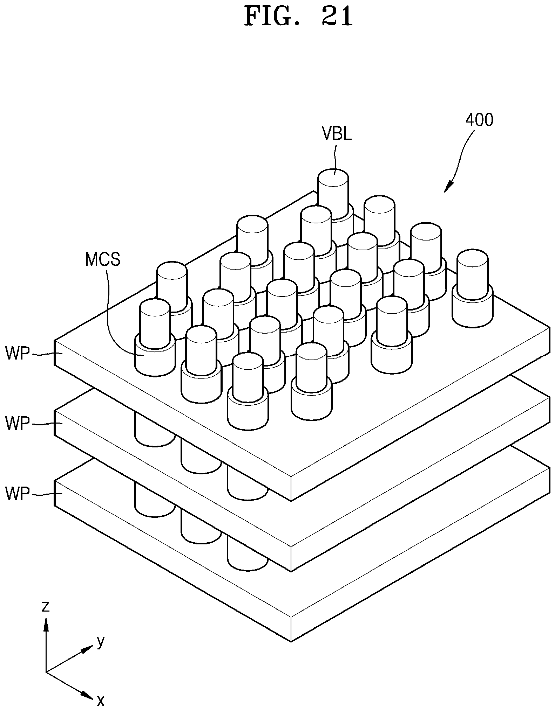

FIG. 21 is a perspective view schematically showing a memory device 400 according to at least one embodiment.

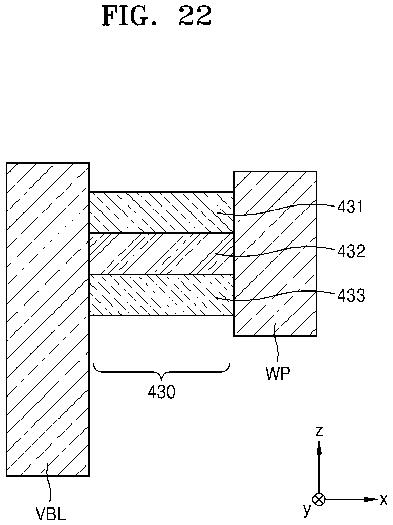

Referring to FIG. 21, the memory device 400 may include a plurality of word planes WP that extend along a plane including the first direction and the second direction and are spaced apart from one another along a third direction (that is, z-axis direction) crossing the first and second directions, a plurality of vertical bit lines VBL that extend in the third direction and are two-dimensionally arranged along the first direction and the second direction, and a plurality of memory cell strings MCS that extend in the third direction while surrounding surfaces of the plurality of vertical bit lines VBL. The plurality of memory cell strings MCS may be also two-dimensionally arranged in the first and second directions, like the plurality of vertical bit lines VBL. Each of the plurality of memory cell strings MCS and each of the plurality of vertical bit lines VBL may be arranged to pass through the plurality of word planes WP in the third direction. Each memory cell string MCS may include a plurality of memory layers (430 of FIG. 22) arranged in a third direction.

FIG. 22 is a cross-sectional view schematically showing a structure of one memory cell in the memory device 400 of FIG. 21.

Referring to FIG. 22, a word plane WP and the memory layer 430 and the vertical bit line VBL surrounded by the word plane WP may form one memory cell. Here, the memory layer 430 may be provided to surround the side surface of the vertical bit line VBL. The word plane WP and the vertical bit line VBL may respectively correspond to the first electrode 110 and the second electrode 120 of the memory device 100 shown in FIG. 6A. The memory layer 430 may include a plurality of memory material layers 431, 432, and 433 having different threshold voltages. The memory layer 430 may correspond to the memory layer 130 of the memory device 100 shown in FIG. 6A.

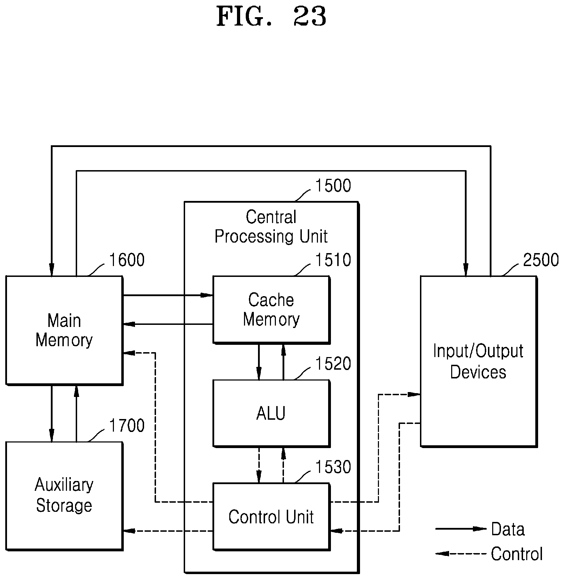

The memory device 100, 200, 300 or 400 according to the embodiment as described above may be used to store data in various electronic apparatuses. FIG. 23 is a conceptual diagram schematically showing device architectures applied to an electronic apparatus, according to at least one embodiment.

Referring to FIG. 23, a cache memory 1510, an ALU 1520, and a control unit 1530 may configure a central processing unit 1500, and the cache memory 1510 may include a static random-access memory (SRAM). Separately from the CPU 1500, a main memory 1600 and an auxiliary storage 1700 may be provided. The main memory 1600 may include a DRAM device, and the auxiliary storage 1700 may include the memory device 100 or 200 described above. In some cases, input/output devices 2500 may be provided. In some cases, a device architecture may be implemented in a form in which computing unit devices and memory unit devices are adjacent to each other in one chip, without distinction of sub-units.

The memory device 100, 200, 300, and 400 according to the embodiments may be implemented as a chip-type memory block to be used as a neuromorphic computing platform or used to construct a neural network.

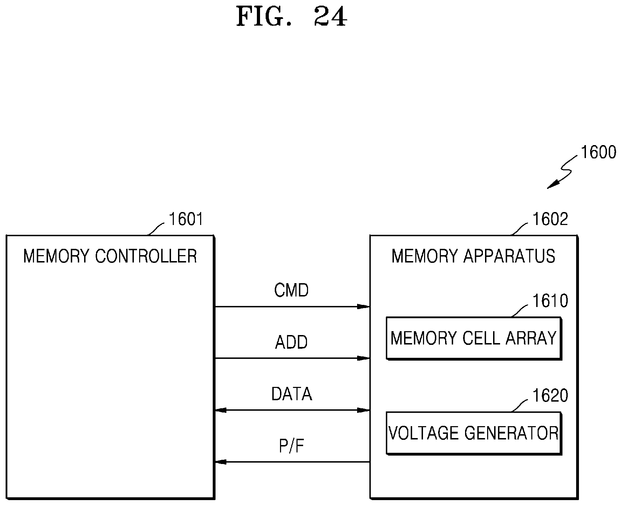

FIG. 24 is a block diagram of a memory system 1600 according to at least one embodiment.

Referring to FIG. 24, the memory system 1600 may include a memory controller 1601 and a memory device 1602. The memory controller 1601 performs a control operation on the memory device 1602, for example, the memory controller 1601 may provide the memory device 1602 with a command CMD for performing a programming (or recording), reading, and/or erasing operation on an address ADD and the memory device 1602. Also, data for the programming operation and read data may be transferred between the memory controller 1601 and the memory device 1602.

The memory device 1602 may include a memory cell array 1610 and a voltage generator 1620. The memory cell array 1610 may include a plurality of memory cells and may include the memory device 100, 200, 300 or 400 according to at least one embodiment.

The memory controller 1601 may include a processing circuit such as hardware including a logic circuit, a combination of hardware/software such as processor executed software, or a combination thereof. For example, the processing circuit may include, in particular, a central processing unit (CPU), an arithmetic logic unit (ALU), a digital signal processor, a micro-computer, a field programmable gate array (FPGA), a system-on-chip (SoC), a programmable logic unit, a micro-processor, an application-specific integrated circuit (ASIC), etc., but is not limited thereto. The memory controller 1601 may operate in response to a request from a host (not shown) and may access the memory device 1602 to control the control operation (e.g., recording/reading operation) discussed as above, and thus, the memory controller 1601 may be converted into a special purpose controller. The memory controller 1601 may generate an address ADD and a command CMD for performing programming/reading/erasing operations on the memory cell array 1610. Also, in response to the command from the memory controller 1601, the voltage generator 1620 (e.g., power circuit) may generate a voltage control signal for controlling a voltage level of a word line in order to perform data programming or data reading on the memory cell array 1610.

Also, the memory controller 1601 may perform a determination operation with respect to the data read from the memory device 1602. For example, from the data read from the memory cell, the number of on-cells and/or the number of off-cells may be determined. The memory device 1602 may provide the memory controller 1601 with a pass/fail signal (P/F) according to the determination result with respect to the read data. The memory controller 1601 may control the writing/reading operation of the memory cell array 1610 with reference to the pass/fail signal (P/F).

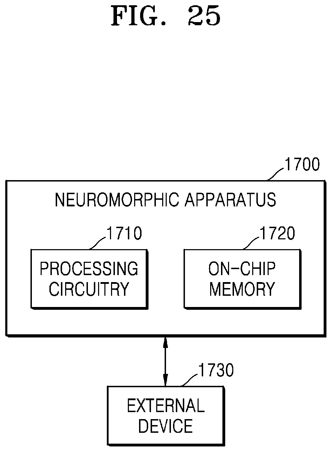

FIG. 25 is a block diagram showing a neuromorphic device 1700 and an external device connected to the neuromorphic device according to at least one embodiment.

Referring to FIG. 25, the neuromorphic device 1700 may include a processing circuit 1710 and/or an on-chip memory 1720. The neuromorphic device 1700 may include the memory device 100, 200, 300, or 400 according to the embodiment.

In some embodiments, the processing circuit 1710 may be configured to control functions for driving the neuromorphic device 1700. For example, the processing circuit 1710 may be configured to control the neuromorphic device 1700 by executing a program stored in the on-chip memory 1720. In some embodiments, the processing circuit 1710 may include hardware such as a logic circuit, hardware/software combination such as a processor executing software, or a combination thereof. For example, the processor may include, but is not limited to, a CPU, a graphic processing unit (GPU), an application processor (AP) included in the neuromorphic device 1700, an ALU, a digital signal processor, a micro-computer, a FPGA, an SoC, a programmable logic unit, a micro-processor, an ASIC, etc. In some embodiments, the processing circuit 1710 may be configured to read/record various data with respect to an external device 1730 and/or to execute the neuromorphic device 1700 by using the read/recorded data. In some embodiments, the external device 1730 may include an external memory and/or sensor array having an image sensor (e.g., CMOS image sensor circuit).

In some embodiments, the neuromorphic device 1700 of FIG. 25 may be applied to a machine learning system. The machine learning system may use various artificial neural network organization and processing models, such as a convolution neural network (CNN), a de-convolution neural network, a repeated neural network (RNN) selectively including a long short-term memory (LSTM) unit and/or gated recurrent unit (GRU), a stacked neural network (SNN), a state-space dynamic neural network (SSDNN), deep belief network (DBN), a generative adversarial network (GAN) and/or restricted Boltzmann machine (RBM).

Alternatively and/or additionally, such machine learning systems may include other types of machine learning models, for example, linear and/or logistic regression, statistics clustering, Bayesian classification, determination trees, dimensional reduction such as main component analyses, expert systems, and/or random forests; or a combination thereof. The machine learning models may be used to provide various services and/or applications. For example, an image classification service, a user authentication service based on biometric information or biometric data, an advanced driver assistance system (ADAS) service, a voice assistance service, an automatic speech recognition (ASR) service, etc. may be executed by an electronic device.

According to the memory device of the embodiments, the memory layer includes a plurality of memory material layers including a chalcogenide-based material and having different threshold voltages, and each of the memory material layers has an OTS characteristic and is formed to have the threshold voltage varying depending on the polarity and intensity of an applied voltage, and thus, the multi-level memory may be effectively implemented.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A memory cell comprising:
a first electrode and a second electrode spaced apart from each other; and
a memory layer between the first electrode and the second electrode, the memory layer including a plurality of memory material layers having different threshold voltages from each other,
wherein each of the plurality of memory material layers includes
a chalcogenide-based material,
has an ovonic threshold switching (OTS) characteristic, and
is configured to have a threshold voltage varying with a polarity and an intensity of an applied voltage.

2. The memory cell of claim 1, wherein each of the plurality of memory material layers includes a chalcogen element including at least one of Se and Te, and at least one of Ge, As, or Sb, and optionally wherein at least one of the plurality of memory material layers further includes at least one of In, Al, C, B, Sr, Ga, O, N, Si, Ca, P, or S.

3. The memory cell of any preceding claim, wherein the plurality of memory material layers have different threshold voltages from each other according to a composition or the composition and a thickness thereof.

4. The memory cell of any preceding claim, wherein the plurality of memory material layers perpendicularly to the first and second electrodes and are electrically connected to one another in parallel, and optionally wherein, when a number of the plurality of memory material layers is n, 2*(n+1) level states are implemented.

5. The memory cell of claim 4, wherein the plurality of memory material layers are in parallel to each other when in a plan view.

6. The memory cell of claim 4, wherein the plurality of memory material layers are in concentric circles when in a plan view.

7. The memory cell of any preceding claim, wherein each of the plurality of memory material layers is configured to implement a low-threshold voltage state and a high-threshold voltage state using writing voltage pulses of different polarities.

8. A memory device comprising:
a plurality of memory cells according to any preceding claim.

9. The memory device of claim 8, wherein each of the plurality of memory material layers includes a chalcogen element including at least one of Se or Te, and at least one of Ge, As, or Sb, and optionally wherein at least one of the plurality of memory material layers further includes at least one of In, Al, C, B, Sr, Ga, O, N, Si, Ca, P, or S.

10. The memory device of claim 8 or 9, wherein the plurality of memory material layers have different threshold voltages from each other according to a composition or the composition and a thickness thereof.

11. The memory device of claim 8 or 9, wherein the plurality of memory material layers are perpendicularly to the first and second electrodes and are electrically connected to one another in parallel, and optionally wherein, when a number of the plurality of memory material layers is n, the memory cell is configured to implement 2*(n+1) level states.

12. The memory device of any of claims 8 to 11, wherein each of the plurality of memory material layers is configured to implement a low-threshold voltage state and a high-threshold voltage state using writing voltage pulses of different polarities.

13. The memory device of any of claims 8 to 12, further comprising:
a plurality of bit lines extending in a first direction, and
a plurality of word lines extending in a second direction crossing the first direction,
wherein the plurality of memory cells are respectively provided at points where the plurality of bit lines and the plurality of word lines cross each other.

14. The memory device of any of claims 8 to 13, further comprising:
a plurality of word planes that extend along a plane including a first direction and a second direction and spaced apart from each other in a third direction, and
a vertical bit line passing through the plurality of word planes and extending in the third direction,
wherein the memory layer is between the vertical bit line and each of the word planes, and optionally wherein the plurality of memory material layers are stacked in the third direction.

15. An electronic apparatus comprising the memory device of any of claims 8 to 14.
